# EUROPEAN PATENT SPECIFICATION

(11) **EP 0 536 394 B1**
(45) Date of publication and mention of the grant of the patent: **15.05.1996**
(21) Application number: 90909847.7
(22) Date of filing: 27.06.1990
(51) Int. Cl.: C01B 33/035, C30B 13/00, C30B 15/00, C30B 29/06

(54) **METHOD OF PRODUCING POLYCRYSTALLINE SILICON RODS FOR SEMICONDUCTORS AND THERMAL DECOMPOSITION FURNACE THEREFOR**
VERFAHREN ZUR HERSTELLUNG VON POLYKRISTALLINEN SILIZIUMSTÄBEN FÜR HALBLEITER SOWIE DAFÜR GEEIGNETER OFEN ZUR THERMISCHEN ZERSETZUNG
PROCEDE DE FABRICATION DE BARRES DE SILICIUM POLYCRISTALLIN POUR SEMI-CONDUCTEURS, ET FOUR DE DECOMPOSITION THERMIQUE A CET EFFET

(43) Date of publication of application: 14.04.1993
(73) Proprietor: KOMATSU ELECTRONIC METALS CO., LTD, Hiratsuka-shi Kangawa 254 (JP)
(72) Inventor: YATSURUGI, Yoshifumi, 1643, Endo, Kanagawa 252 (JP); NAGAI, Kenichi, 5-10, Yakumo 4-chome, Tokyo 152 (JP); IZAWA, Junji, 429-4, Togawa, Kanagawa 259-13 (JP); OHTSUKI, Minoru, 179-1, Tsuchiya, Kanagawa 259-12 (JP); MIYAMOTO, Yusuke, 301-4, Irino, Kanagawa 259-12 (JP)
(74) Representative: Baverstock, Michael George Douglas
(86) International application number: JP9000833
(87) International publication number: WO9200245

(56) References cited:
- EP-A- 0 324 504
- JP-A-61 101 410
- JP-B-56 045 850

## Description

This invention relates to an improved method for manufacturing semi-conductive polycrystalline silicon rods which are used for elements in manufacturing semi-conductive silicon single-crystals, by the float zone melting process (hereinafter called FZ process) and the Czochralski process (hereinafter called CZ process) and to a thermal decomposition furnace for manufacturing the silicon rods.

In manufacturing semi-conductive polycrystalline silicon rods as materials for producing semi-conductive silicon single-crystals according to the known FZ process or CZ process, silicon is deposited on silicon filaments by effecting thermal decomposition and hydrogen reduction using chloride type silanes such as trichlorosilane in place of monosilane gas which is the gaseous material used in the present invention.

Such representative examples of a structure of the thermal decomposition furnace proposed for the manufacture of semi-conductive polycrystal silicon rods are already disclosed in Japanese Patent Publication No. 51-37253 and Patent Kokai No. 56-105622 wherein a plurality of silicon filaments or high melting point metal filaments are erected in a shield-free furnace to deposit silicon thereon thereby making semi-conductive polycrystalline silicon rods. However, the decomposition reaction of the gaseous monosilane to be the material used in the present invention differs from that of the chloride type silanes at high temperature. Even though a furnace having the same mode of structure as the thermal decomposition furnace of said chloride type silanes can be employed as the thermal decomposition furnace of monosilane gas it is well-known to those skilled in the art that the thermal decomposition furnace of chloride type silanes has very poor efficiency. That is, the most significant differences in a decomposition reaction in the case of monosilane gas are that the homogeneous reaction takes place quickly in the gas phase and that thermally decomposed powdery silicon is likely to be produced more easily than with chloride type silane.

Japanese Patent Publication No. 56-45850 discloses a known technique concerning means of avoiding the formation of powdery silicon. This known technique is characterized by provision of a heat-radiation shield having a cooling mechanism for radiation heat generated between the silicon filaments to allow the homogeneous reaction in the gas phase to be suppressed.

In the process of manufacturing semi-conductive polycrystalline silicon rods it is known that if powdery silicon is used in the silicon rods the undermentioned disadvantages occur in producing semi-conductive silicon single-cystals. That is, in the material used in the FZ process there is formed a float zone where a part of a semi-conductive polycrystalline silicon rod is molten for single crystallization. Powdery silicon stays floating, without being melted, on the molten silicon liquid the powdery silicon adheres to spots of growing single-crystals and the crystals are disturbed at said spots as nuclei and as a result such silicon rods cannot be used as a final product.

The same bad influence is given even upon the material employed in the CZ process. In such a process, semi-conductive polycrystalline silicon rods broken to the size of a fist are charged into a quartz crucible to permit said silicon masses to be molten. At that time there is necessarily observed a phenomenon that the powdery silicon mixed or involved into the silicon liquid floats up to the surface of the molten liquid as described above.

The semi-conductive polycrystalline silicon rods into which said powdery silicon is thus incorporated are mentioned as one example of an improper quality element.

Thus, preferably, a pyrolysis furnace employed for the thermal decomposition of monosilane gas as its starting material is of the construction as described in said Japanese Patent Publication No. 56-45850. As the techniques in the semi-conductor field have greatly advanced these days, however, semi-conductive silicon single-crystal rods ranging up to a 6 inch thick diameter are required and following such demand greater thickness and length are required also for semi-conductive polycrystalline silicon rods employed as starting materials. Additionally, whether the FZ process or the CZ process, reduction of cost for the materials to be used has been strictly demanded year by year. Thus an effective mass production based on scaling-up is mentioned as one of the measurements of solving the reduction of cost, it is known that said Patent Publication No. 56-45850 does not sufficiently achieve the effect only by the scaling-up of the construction based on the invention of said publication to obtain semi-conductive polycrystalline silicon rods not incorporating said powdery silicon. Further, when using a method where semi-conductive polycrystalline silicon rods having thicker diameter and greater length are charged in a larger quantity, powdery silicon increases in production by the subsequent homogeneous reaction in the gas phase thereby making it impossible to achieve the effect.

In the phenomenon where in the manufacturing process of semi-conductive polycrystalline silicon rods powdery silicon is incorporated into said silicon rods, it has been found as the result of experimental observations that the powdery silicon thermally decomposed by a homogeneous reaction in the gas phase in a thermal decomposition furnace floats up so as to accumulate at the ceiling wall, side walls or the like of the thermal decomposition furnace to form a thin powder-adhered layer, and when the layer thickens to a certain extent it cracks so that the thus cracked small solids fall down to adhere to the surface of the semi-conductive polycrystalline silicon rods and the same result is observed even if the powder silicon produced in a homogeneous reaction in the gas phase floats up in a large scale.

The formation of powdery silicon which causes said disadvantages, i.e. the homogeneous reaction speed in the gas phase depends greatly on the concentration and decomposition temperature of monosilane gas. In order to manufacture thicker and longer semi-conductive polycrystalline rods at lower cost, the formation of said powdery silicon is suppressed as much as possibe and silicon filaments having a thinner diameter are started at their optimum deposition speed until they become thicker. By doing this it is possible to greatly reduce the costs which are incurred in operation, such as reduction of quantitities of electricity and cooling water, as well as to reduce the operation time period. However, as the diameter of the semi-conductive polycrystalline silicon rods to be manufactured increases the area radiating heat from each of the red-hot silicon rods increases and the reaction in the gas phase is promoted thereby increasing the amount of the powdery silicon generated. The same phenomenon takes place even if the rods are of greater length and their charging amount increases.

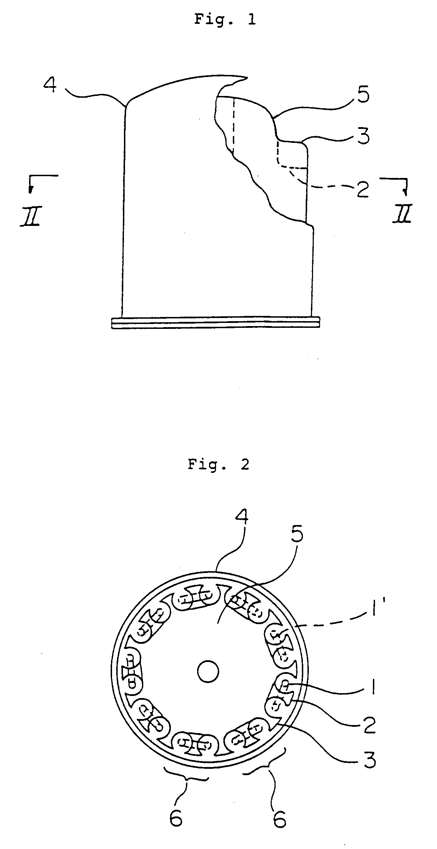

To avoid such phenomenon Japanese Patent Publication No. 56-45850 discloses a technique of isolating the heated silicon rods by a heat-shielding plate so as to shield the radiant heat between the silicon rods. However, when a number of heated silicon filaments are set in a single pyrolysis furnace, intending to grow said silicon rods thicker and longer, it becomes impossible to ignore the effect of the bridges. As shown by way of a simulated cross sectional view in Figure 1, since the bridge portions of the inverted U-shaped heated silicon filaments are open into the neighbouring thermal decomposition chamber, the heat radiation from the heated silicon rods cannot be avoided in the neighbourhood of the top of the thermal decomposition chamber. Thus, because powdery silicon is generated in a large quantity the powdery silicon is caused to be incorporated into the semi-conductive crystal silicon rods thereby causing troubles in manufacturing semi-conductive silicon single-crystals.

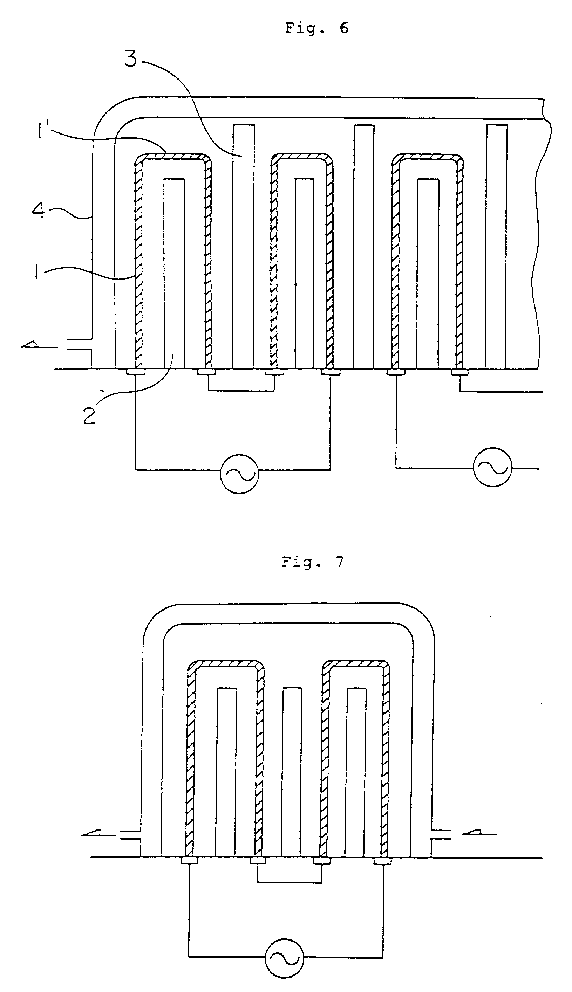

Thus, isolation of each pair of the bridge portions by a shield is an effective and powerful means for decelerating the homogeneous reaction speed in the gas phase. That is, as illustrated with a simulated cross sectional view in Figure 6, a single thermal decomposition chamber is isolated by inverted U-shaped heated silicon filaments to shield the heat radiation generated between the bridges of said silicon filaments and to position the heated silicon filaments in the respective centers of the cylinders whereby the asymmetry of the sectional shape as found in the invention of Patent Publication No. 56-45850 is eliminated from the periphery of each heated silicon filaments and the gas flows evenly. Owing to such action the concentration of the monosilane gas to be the starting material necessarily becomes uniform, when the homogeneous reaction in gas phase is reduced in the uneven concentration sites based on imbalance flow, particularly in greater concentration sites. This makes it possible to produce thicker and longer silicon rods at an effective, good-growing rate and in large quantity charging.

EP-A-324 504 describes a method of forming polycrystalline rods by pyrolysis of silane on an array of heated filament starter rods. However, the legs of the U-shaped heated silicon rods do not have cooled shields positioned between them.

Thus, the present invention relates to a method of manufacturing high-purity, semi-conductive, polycrystalline silicon rods by subjecting monosilane gas to thermal decomposition to deposit silicon on a plurality of silicon filaments (1) heated by electric current directly therethrough while shielding the heat between said silicon filaments and shielding radiant heat from the bridge portion (1') which electrically connects the individual heated silicon filaments characterized in that the individual inverted U-shaped silicon carrier members (1) are arranged across a cooled shield (2) on the central axis of each of pairs of individual cylindrical thermal decomposition chambers which are isolated by cooled shields (3) whereby the monosilane gas is decomposed at a uniform flow rate and concentration. The invention further relates to a thermal decomposition furnace for manufacturing semi-conductive polycrystalline silicon rods said furnace having electrical connections, a guide portion for the gas to be decomposed, and a gas discharge portion, said thermal decomposition furnace comprising an outer cylinder (4) and an inner cylinder (5) each having a cooling structure, the outer periphery of said inner cylinder being provided with a plurality of thermal decomposition chambers (6) in which inverted U-shaped electrically heated silicon filaments (1) can be arranged, each individual thermal decomposition chamber being provided at its center with a low shield (2) the bridge portions (1') of said silicon filaments being capable of arrangement across the shield without contacting it, and said outer periphery of the thermal decomposition chamber comprising a high shield (3), both the low shield (2) and the high shield (3) being provided with a cooling mechanism.

The invention will now be described more in detail, by way of example, with reference to the accompanying drawings in which:
Figures 1 to 3 are respectively a side view, a cross sectional view, and a perspective view of the outer periphery of the inner cylinder, showing one embodiment of the thermal decomposition furnace of the present invention;
Figure 4 and Figure 5 are respectively a side view and a cross sectional view showing another embodiment of the thermal decomposition furnace of the invention;
Figure 6 is a simulated view explaining the principle of the thermal decomposition furnace of the invention; and
Figure 7 is a similar simulated view of a known system thermal decomposition furnace.

According to one embodiment of the thermal decomposition furnace of the invention illustrated in Figures 1 to 3, an outer cylinder (4) and an inner cylinder (5) are provided with a cooling mechanism, and said inner cylinder (5) is provided in its outer periphery with a plurality of cylindrical, thermal decomposition chambers (6) each of which contains inverted U-shaped silicon filaments (1). A unit thermal decomposition chamber (6) has at its center a low shield (2) and the bridge portion (1') of said silicon filaments (1) is of such height that it can cross said low shield (2) but is not brought into contact therewith. The outer circumference of said thermal decomposition chamber (6) is made of a high shield (3) which is constructed to separate other thermal decomposition chamber units. Additionally, these high and low shields (3), (2) are provided with cooling mechanisms (not shown) respectively.

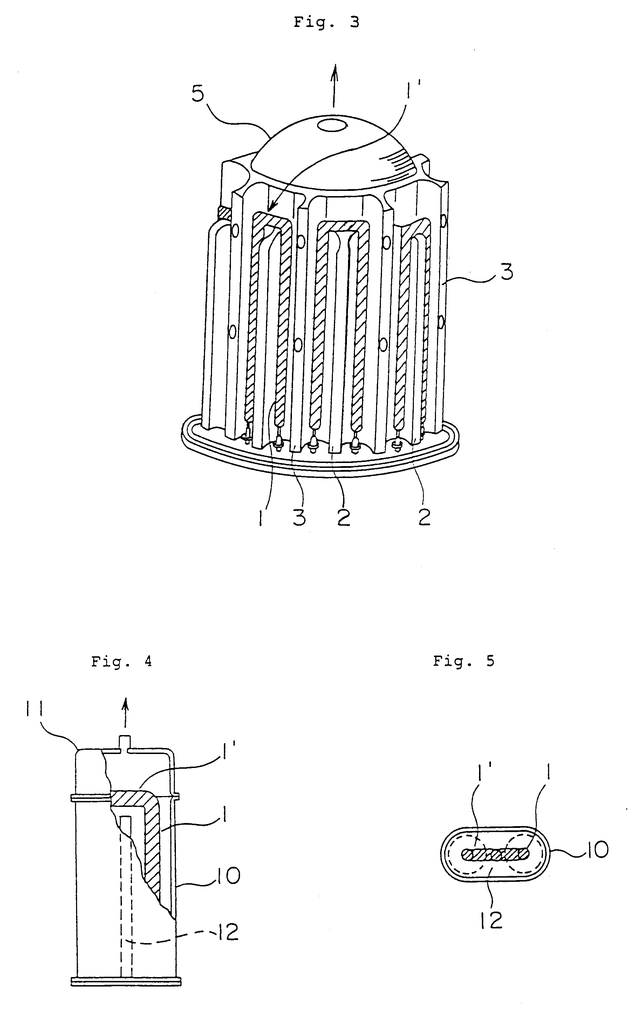

According to another embodiment of the thermal decomposition furnace of the invention, which is illustrated in Figures 4 and 5, the furnace consists of a portion (10) for storing the inverted U-shaped silicon filaments and a disengageable cover (11), said storing portion (10) is provided at its center with a partition (12), each of the thermal decomposition chambers is of cylindrical shape, the height of said partition (12) extends not to contact its bridge portion (1') in the case of setting inverted U-shaped silicon rods (1) to the central axis of each thermal decomposition chamber. Additionally, the thermal decomposition furnaces can be arranged in plurality in which case they can be electrically connected (not shown), decomposition gas can be guided, and the charging can be done in parallel.

Next, the experimental result of the present invention is described below.

### EXAMPLE 1

Eighteen silicon filaments (1), each having a diameter of 7 mm and a length of 2,000 mm, were set in a thermal decomposition furnace as shown in FIGS. 1 to 3, and the respective unit silicon filaments are connected with one another by respective bridges (1') while holding low shielding plates (2) therebetween thereby directly, electrically heating the silicon filaments. The respective silicon filaments are set in the center of a cylindrical zone enclosed by an outer cylinder (4) and an inner cylinder (5), and the bridge portion of a unit silicon filaments is isolated from neighboring unit silicon filaments through high shields (3). The speed of growth of each silicon rod by the thermal decomposition reaction was kept at 4 µm/min until the diameter of each rod reached 80 mm. This means that compared with the period of time during which four silicon filaments having a length of 1,200 mm were grown until the diameter of each reached 80 mm as above in a conventional thermal decomposition furnace i.e. the one as described in Patent Publication No. 56-45850, the period of time could be shortened by about 10% despite the increase in number and length of the pieces of silicon filaments.

### EXAMPLE 2

Six sets of the thermal decomposition furnace as shown in FIG. 2 were manufactured. Since the gas line system, the power source system, the control system and the like are carried out in one place the six sets of thermal decomposition furnace form substantially a single apparatus. The silicon filaments of the same size as in EXAMPLE 1 were set in these thermal decomposition furnaces to grow them at a speed of 4.5 µm/min until their diameters reached 90 mm, when mixing or incorporation of powdery silicon was not observed. It was confirmed that because of the symmetrical shape of the spaces around the silicon filaments it was possible to manufacture the silicon rods thicker and longer and in more quantity at a shorter period of time than in the conventional system.

The functions and effects of the present invention are enumerated as follows.
(1) The material of the bridges which are used in manufacturing the semi-conductive polycrystal silicon rods are either silicon rod or metallic rod having a high melting point, but since the bridges need to be insulated from the furnace walls they must be separated from the walls. Conventionally, the upper portions of the silicon filaments and the bridge portions were not shielded. However, now that thicker and longer silicon rods are demanded in a large quantity charging as described above, it is not possible to ignore the heat radiated from the bridge portions. To ensure a complete heat shielding, therefore, the structure of the present furnace is made to isolate the whole circumference of each bridge. Thus, compared with the manufacture according to the known structure it is now possible to manufacture thicker and longer and in larger quantity at a shorter period of time.
(2) Further, by positioning single silicon filaments in the center of a cooled cylindrical shield the gas rises become symmetrical about the silicon filaments. Since the depositing rate of the silicon upon the silicon filaments is determined by the feeding speed of the monosilane to the material gas, the gaseous starting material is consumed in even quantity in any part so as to solve the irregularity of concentration if, as described above, the gas flow rate around the silicon filaments retains symmetry. The decomposition reaction in the gas phase mostly proceeds at the places of maximum concentration, so that conventionally the conditions of total thermal decomposition had to meet said portions of maximum concentration. However, since such requirements are no longer needed it is possible to aim at reducing the cost and improving the productivity to a greater extent.
(3) Even according to the known structure of the thermal decomposition furnace it was capable of producing thicker silicon rods by decreasing the supplied amount of monosilane gas and lowering the monosilane concentration, but the productivity was too poor. Even such a case had a limitation, and the maximum diameter of the silicon rods which could be produced without mixing or incorporation of powdery silicon was at most 100 mm. According to the present invention, however, it suffices just to retard the growing speed a little even when producing a product having a 100 mm diameter.

As described above in detail, the present invention meets such demands as improving the productivity, reducing the cost, and presenting products of thicker diameter and the products can be presented at a shorter period of time than in the conventional technique whereby many effects can be produced.

## Claims

1. A method of manufacturing high-purity, semi-conductive, polycrystalline silicon rods by subjecting monosilane gas to thermal decomposition to deposit silicon on a plurality of silicon filaments (1) heated by electric current directly therethrough while shielding the heat between said silicon filaments and shielding radiant heat from the bridge portion (1') which electrically connects the individual heated silicon filaments characterized in that the individual inverted U-shaped silicon carrier members (1) are arranged across a cooled shield (2) on the central axis of each of pairs of individual cylindrical thermal decomposition chambers which are isolated by cooled shields (3) whereby the monosilane gas is decomposed at a uniform flow rate and concentration..

2. A thermal decomposition furnace for manufacturing semi-conductive polycrystalline silicon rods said furnace having electrical connections, a guide portion for the gas to be decomposed, and a gas discharge portion, said thermal decomposition furnace comprising an outer cylinder (4) and an inner cylinder (5) each having a cooling structure, the outer periphery of said inner cylinder being provided with a plurality of thermal decomposition chambers (6) in which inverted U-shaped electrically heated silicon filaments (1) can be arranged, each individual thermal decomposition chamber being provided at its center with a low shield (2) the bridge portions (1') of said silicon filaments being capable of arrangement across the shield without contacting it, and said outer periphery of the thermal decomposition chamber comprising a high shield (3), both the low shield (2) and the high shield (3) being provided with a cooling mechanism.

## Patentansprüche

1. Verfahren zur Herstellung hochreiner, halbleitender, polykristalliner Siliziumstäbe, indem Monosilangas einer thermischen Zersetzung unterworfen wird, um Silizium auf einer Vielzahl von Siliziumfäden (1) abzulagern, die durch elektrischen Strom direkt erhitzt werden, während die Hitze zwischen den Siliziumfäden abgeschirmt wird und die Strahlungswärme gegen den Brückenabschnitt (1') abgeschirmt wird, der die individuellen, erhitzten Siliziumfäden elektrisch verbindet, **dadurch gekennzeichnet, daß** die individuellen, invertiert U-förmigen Siliziumträgerelemente (1) über einem gekühlten Schutzschild (2) auf der Mittelachse von jedem Paar individueller zylindrischer thermischer Zersetzungskammern angeordnet werden, die durch gekühlte Schutzschilde (3) isoliert werden, wobei das Monosilangas bei einer einheitlichen Fließgeschwindigkeit und Konzentration zerlegt wird.

2. Ofen für thermische Zersetzung zur Herstellung von halbleitenden, polykristallinen Siliziumstäben, wobei der Ofen elektrische Verbindungen, ein Leitungsteil für das zu zersetzende Gas und ein Gasauslaßteil aufweist, der Ofen für thermische Zersetzung einen Außenzylinder (4) und einen Innnenzylinder (5) aufweist, wobei jeder einen kühlenden Aufbau aufweist, die Außenperipherie des Innnenzylinders mit einer Vielzahl von thermischen Zersetzungskammern (6) versehen ist, in denen invertiert U-förmige, elektrisch erhitzte Siliziumfäden (1) angeordnet werden können, jede individuelle thermische Zersetzungskammer in der Mitte mit einem niedrigen Schutzschild (2) versehen ist, die Brückenabschnitte (1') der Siliziumfäden für eine Anordnung über dem Schutzschild geeignet sind, ohne ihn zu berühren, und die Außenperipherie der thermischen Zersetzungskammer einen hohen Schutzschild (3) aufweist, wobei sowohl der niedrige Schutzschild (2) als auch der hohe Schutzschild (3) mit einer Kühleinrichtung versehen sind.

## Revendications

1. Procédé de fabrication de tiges de silicium polycristallin, semi-conductrices, de grande pureté, en soumettant un gaz monosilane à la décomposition par la chaleur pour déposer du silicium sur plusieurs filaments de silicium (1) chauffés par du courant électrique qui les parcourt directement, tout en protégeant de la chaleur entre lesdits filaments de silicium et en protégeant de la chaleur rayonnée par la partie pont (1') qui relie électriquement les filaments de silicium individuels chauffés ; caractérisé en ce que les éléments supports en silicium (1) individuels en forme de U inversé sont agencés dans une zone refroidie (2) sur l'axe central de chacune de paires de chambres cylindriques individuelles de décomposition par la chaleur qui sont séparées par des écrans refroidis (3), ce par quoi le gaz monosilane est décomposé avec un débit et une concentration uniformes.

2. Four de décomposition par la chaleur pour fabriquer des tiges semi-conductrices de silicium polycristallin, ledit four comportant : des connexions électriques ; une partie de guidage pour le gaz à décomposer ; et une partie d'évacuation de gaz, ledit four de décomposition par la chaleur comprenant un cylindre extérieur (4) et un cylindre intérieur (5) ayant chacun une structure de refroidissement, la périphérie extérieure dudit cylindre intérieur étant pourvue de chambres de décomposition par la chaleur (6), dans lesquelles on peut disposer des filaments de silicium (1), en forme de U inversé, chauffés électriquement, chaque chambre individuelle de décomposition par la chaleur étant pourvue, en son centre, d'un écran bas (2), les parties ponts (1') desdits filaments de silicium pouvant traverser ledit écran sans le contacter, et ladite périphérie extérieure de la chambre de décomposition par la chaleur comprenant un écran haut (3), l'écran bas (2) et l'écran haut (3) étant tous les deux pourvus d'un système de refroidissement.
